(19) Europäisches Patentamt

European Patent Office

Office européen des brevets

(11) **EP 1 905 870 A2**

(12) **EUROPEAN PATENT APPLICATION**

(43) Date of publication:
**02.04.2008 Bulletin 2008/14**

(51) Int Cl.:
***C23C 30/00*** (2006.01)

(21) Application number: **07108208.5**

(22) Date of filing: **15.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **27.09.2006 US 527711**

(71) Applicant: **Seco Tools AB**
**737 82 Fagersta (SE)**

(72) Inventor: **RUPPI, Sakari**
**737 44 Fagersta (SE)**

(54) **Alumina layer with enhanced texture**

(57) The present invention relates to a coated cutting tool insert comprising a substrate and a coating to be used in metal machining. The hard and wear resistant coating exhibits an excellent adhesion to the substrate covering all functional parts thereof. The coating is composed of one or more refractory layers of which at least one layer is $\alpha$-$Al_2O_3$ showing a strong growth texture along <001>. The $\alpha$-$Al_2O_3$ layer has a thickness ranging from 1 to 20 $\mu$m and is composed of columnar grains with a length/width ratio of 2 to 15. The layer is characterised by a strong (006) diffraction peak, measured using XRD, and by low intensity of (012), (104), (113) (024) and (116) diffraction peaks. The <001>textured $\alpha$-$Al_2O_3$ layers are deposited in a temperature range of 750-1000°C. The texture is controlled by a specific nucleation procedure combined with the use of sulphur- and fluorine containing dopants.

Fig 1a

Fig 1b

**Fig.1**

EP 1 905 870 A2

**Description**

The present invention relates to a coated cutting tool insert designed to be used in metal machining. The coating exhibits an excellent adhesion to the substrate covering all functional parts thereof. The coating is composed of one or more refractory layers of which at least one is an $\alpha$-Al$_2$O$_3$-layer strongly textured in the <001>direction.

Background of the invention

Techniques to deposit $\alpha$-Al$_2$O$_3$ and $\kappa$-Al$_2$O$_3$-layers with total nucleation control were only recently introduced on an industrial scale and it has clearly been shown that $\alpha$-Al$_2$O$_3$ is the preferred phase in most metal cutting applications.

It has been experimentally confirmed that $\alpha$-Al$_2$O$_3$ can be nucleated, for example, on Ti$_2$O$_3$ surfaces, bonding layers of (Ti,Al)(C,O) or by controlling the oxidation potential using CO/CO$_2$ mixtures. The idea in all these approaches is that nucleation must not take place on the surfaces of TiC, TiN, Ti(C,N) or Ti(C,O,N) with fcc structure, otherwise $\kappa$-Al$_2$O$_3$ is obtained.

All the prior-art methods are using nucleation control in order to obtain the growth textures. As described in a recent publication (S. Ruppi, Deposition. Microstructure and properties of texture-controlled CVD $\alpha$-Al2O3 coatings, Int. J. Refractory Metals & Hard Materials 23(2005) 306-315) manipulation of the nucleation surfaces can be used to obtain the growth textures of <012>, <104> or <003>. However, the (006) peak, which is an indication of the <001>texture, is always missing. Further, it has been noticed that enhanced performance can be obtained through optimising the texture of $\alpha$-Al$_2$O$_3$. It is thus possible to enhance the tool performance by tailoring the $\alpha$-Al$_2$O$_3$ texture for different metal cutting application and work piece materials.

When the nucleation control is not complete, as is the case in many prior-art products, the produced $\alpha$-Al$_2$O$_3$ layers have, at least partly, been formed as a result of the $\kappa$-Al$_2$O$_3 \rightarrow \alpha$-Al$_2$O$_3$ phase transformation. These kinds of $\alpha$-Al$_2$O$_3$ layers are composed of larger grains with transformation cracks. They exhibit much lower mechanical strength and ductility than the textured $\alpha$-Al$_2$O$_3$ layers that are composed of nucleated $\alpha$-Al$_2$O$_3$. Consequently, there is a need to develop techniques to control the nucleation step and growth texture of $\alpha$-Al$_2$O$_3$.

Prior art

The control of the $\alpha$-Al$_2$O$_3$ polymorph in industrial scale was achieved in the beginning of the 1990's with commercial products based on US patent 5,137,774. Later modifications of this patent have been used to deposit $\alpha$-Al$_2$O$_3$ with preferred textures. In US 5,654,035 an alumina layer textured in the <012> direction and in US 5,980,988 in the <110> direction are disclosed. In US 5,863,640 a preferred growth either along <012>, or <104> or <110> is disclosed. US 6,333,103 describes a modified method to control the nucleation and growth of $\alpha$-Al$_2$O$_3$ along the <10(10)> direction. US 6,869,668 describes a method to obtain a strong <300> texture in $\alpha$-Al$_2$O$_3$ using a texture modifying agent (ZrCl$_4$). The prior-art processes discussed above use all deposition temperatures of about 1000 °C.

US 2004/0028951A1 describes a technique to achieve a pronounced <012> texture. The commercial success of this kind of product demonstrates the importance to refine the CVD process of $\alpha$-Al$_2$O$_3$ towards fully controlled textures.

The commonly observed diffraction peaks from $\alpha$-Al$_2$O$_3$ are (012), (104), (110), (113) and (116). The diffraction peak (006) is always absent in the XRD-patterns obtained from the prior-art textured $\alpha$-Al$_2$O$_3$ layers.

According to the definition used in the International Tables of Crystallography, $\alpha$-Al$_2$O$_3$ belongs to the trigonal crystal system and has a rhombohedrally centred hexagonal lattice, the space group symbol being R3 c. The crystal structure of $\alpha$-Al$_2$O$_3$ is often described as being composed of oxygen ions (A, B) in an approximate hcp arrangement (...ABAB...) with the aluminium anions occupying two thirds of the octahedral interstices. The aluminium cations can take three different vacancy positions in the oxygen lattice with the stacking sequence of ...$\alpha\beta\gamma\alpha\beta\gamma$.... These are usually referred to as c$^\alpha$, c$^\beta$ and c$^\gamma$. The unit cell of $\alpha$-Al$_2$O$_3$ comprises six layers of O and Al can be described in the following way: Ac$^\alpha$Bc$^\beta$Ac$^\gamma$Bc$^\alpha$Ac$^\beta$Bc$^\gamma$.

The JPDS card, referred later on, uses the hexagonal system and, consequently, four axes *(hkil)* are used where i=-(*h*+*k*). Often, the index *i* is omitted as done also in this case.

Objects and summary of the invention

It is an object of the present invention is to provide an improved alumina layer where the $\alpha$-Al$_2$O$_3$ phase consists of nucleated $\alpha$-Al$_2$O$_3$ with a strong, fully controlled <001> growth texture.

It has been surprisingly found that a <001> texture can deposited in a controlled way. It is characterised in the XRD pattern by a strong (006) peak. The alumina layer with strong <001> texture outperforms the prior art with random or other controlled textures. Further, increased toughness can be obtained.

Description of the enclosed drawings and figures

Fig. 1a shows SEM-image of a typical surface morphology of the layer according to this invention in 15000 x.
Fig 1b shows the same layer in cross-section in 15000x.
Fig.2 shows an XRD pattern of an $\alpha$-Al$_2$O$_3$-layer according to this invention for $2\theta$=20-70°.

Detailed description of the invention

According to the present invention there is provided a coated cutting tool insert comprising a substrate and a coating to be used in metal machining.

The substrate comprises a hard material such as cemented carbide, cermets, ceramics, high speed steel or a superhard material such as cubic boron nitride (CBN) or diamond preferably cemented carbide or CBN. With CBN is herein meant a cutting tool material containing at least 40 vol-% CBN. In a preferred embodiment the substrate is a cemented carbide with a binder phase enriched surface zone.

The hard and wear resistant coating exhibits an excellent adhesion to the substrate covering all functional parts thereof. It is composed of one or more refractory layers of which at least one layer is a strongly textured $\alpha$-Al$_2$O$_3$ deposited on a bonding layer of (Ti,Al)(C,O,N) with increasing aluminium content towards the outer surface. The $\alpha$-Al$_2$O$_3$ layer is 1-45 $\mu$m composed of columnar grains with a strong <001> texture. The length/width ratio of the alumina grains is from 2 to 15, preferably>5. The layer is characterised by a strong (006) diffraction peak, measured using XRD, and by low intensity of (012), (104), (113), (024) and (116) diffraction peaks.

The texture coefficients (TC) for the $\alpha$-Al$_2$O$_3$-layer are determined as follows:

$$TC(hkl) = \frac{I(hkl)}{I_0(hkl)} \left\{ \frac{1}{n} \sum \frac{I(hkl)}{I_0(hkl)} \right\}^{-1}$$

where
I(hkl) = intensity of the (hkl) reflection
I$_0$(hkl) = standard intensity according to JCPDS card no 46-1212
n = number of reflections used in the calculation
(hkl) reflections used are: (012), (104), (110), (600), (113) and (116). The (024) reflection, which is the second-order reflection of (012), is omitted from the calculations.
The texture of the alumina layer is defined as follows:
TC(006)>1.4, preferably >3.0 and most preferably >4.0. This is a manifestation of a strong <001> texture.
The texture coefficients for (012), (104), (113), (024) and (116) diffraction peaks are less than 0.5, preferably less than 0.2 and most preferably less than 0.1.

More particularly, the coating comprises a first layer adjacent the substrate of CVD Ti(C,N), CVD TiN, CVD TiC, MTCVD Ti(C,N), MTCVD Zr(C,N), MTCVD Ti(B,C,N), CVD HfN or combinations thereof preferably of Ti(C,N) having a thickness of from 1 to 20 $\mu$m, preferably from 1 to 10 $\mu$m. Preferably there is an intermediate layer of TiN between the substrate and said first layer with a thickness of <3 $\mu$m, preferably 0.5-2 $\mu$m.

In one embodiment the $\alpha$-Al$_2$O$_3$ layer is the uppermost layer.

In another embodiment there is a layer of carbide, nitride, carbonitride or carboxynitride of one or more of Ti, Zr and Hf, having a thickness of from about 0.5 to 3 $\mu$m, preferably 0.5 to 1.5 $\mu$m atop the $\alpha$-Al$_2$O$_3$ layer. Alternatively this layer has a thickness of from about 1 to 20 $\mu$m, preferably 2 to 8 $\mu$m.

In yet another embodiment the coating includes a layer of $\kappa$-Al$_2$O$_3$ and/or $\gamma$-Al$_2$O$_3$ preferably atop the $\alpha$-Al$_2$O$_3$ with a thickness of from 0.5 to 10, preferably from 1 to 5 $\mu$m.

The present invention also relates to a refined method to produce textured $\alpha$-Al$_2$O$_3$ layers in a temperature range of 950-1000°C, preferably at 1000 °C with a controlled <001> texture. The $\alpha$-Al$_2$O$_3$ layer is deposited on a bonding layer of (Ti,Al)(C,O,N) with increasing aluminium content towards the outer surface. On to this layer a Ti(C,O) layer is deposited with controlled O-content. A very thin titanium oxide nucleation layer is obtained in the similar way as used in ALD (Atomic Layer Deposition). The procedure is as follows: (i) exposure of a first precursor TiCl$_4$, preferably together with AlCl$_3$, (ii) purge (N$_2$), (iii) exposure of the second precursor (H$_2$O), (iv) purge (N$_2$). The duration of the steps (i) and (iii) is 1-5 min, preferably 2 min each and the steps (ii) and (iv) 2-10 min, preferably 5 min each. The deposition of the

$\alpha$-Al$_2$O$_3$ is started with a relatively long 30-120 min, preferably 60 min, nucleation step without sulphur- or fluorine containing compounds. $\alpha$-Al$_2$O$_3$ is grown to its desired thickness using sulphur-containing compounds H$_2$S, or SO$_2$, preferably H$_2$S, together with fluorine-containing compounds SF$_6$ or HF, preferably SF$_6$. When $\alpha$-Al$_2$O$_3$ is nucleated correctly, followed by a deposition process using relatively low amounts of these dopants together with a CO+CO$_2$ gas mixture CO=2xCO$_2$ a strong <001> growth texture can be obtained in a controlled way. Important difference compared with the prior-art is that the texture is controlled, in addition to the nucleation procedure, also during the growth of $\alpha$-Al$_2$O$_3$ itself. The described texture cannot be obtained unless both the nucleation and growth are controlled correctly. This is a possible explanation for the fact that the <001> texture [(006) diffraction peak)] has been unknown so far.

Detailed description of the nucleation steps

1. Depositing a bonding layer 0.1-1 $\mu$m thick in a gas mixture of 2-3 % TiCl$_4$ and AlCl$_3$ increasing from 0.5 to 6 %, 3-10 % CO, 1-3 % CO$_2$, 0.2-1.0% CH$_3$CN, 0.2-1.0%, 2-10 % N$_2$ and balance H$_2$ at about 750-1000 °C, preferably at 800°C and at a pressure of 50-200 mbar.
2. Purging by N$_2$ for 5 min.
3. Treating the bonding layer in a gas mixture of 5-15 % TiCl$_4$ and 5-20% CO, 0.5-3% CO$_2$ and 10-20% Ar in hydrogen for 5-15, preferably 10, minutes min at 950-1000°C, preferably at 1000 °C and at a pressure of 50-200 mbar.
4. Purging by N$_2$ for 5 min.
5. Treating the bonding layer in a gas mixture of 8-15% TiCl$_4$ and 0.5-2 %AlCl$_3$ in hydrogen for 5-15 min at 950-1000°C, preferably at 1000 °C and at a pressure of 50-200 mbar.
6. Treating in a gas mixture of 0.05 to 0.5% H$_2$O, preferably 0.01%, balance H$_2$.
7. Purging by N$_2$ for 5 min.
8. Nucleation of the alumina layer at a temperature of 950-1000°C with desired thickness according to known technique or depositing an alumina layer at 950-1000°C without any catalysing precursors.
9. Deposition of the alumina layer at a temperature of 950-1000°C to the desired thickness at 950-1000°C at deposition pressures 50-200mbar using 0.01-0.05% H$_2$S or SO$_2$, preferably H$_2$S and 0.01-0.02 % SF$_6$ or HF, preferably SF$_6$ as catalysing agents. CO$_2$ 1.0-4.5% is used as the oxygen donor together with CO, maintaining CO=2xCO$_2$.

Example 1

Cemented carbide cutting inserts with a composition of 5.9% Co and balance WC (hardness about 1600 HV) were coated with a layer of MTCVD Ti(C,N). The thickness of the MTCVD layer was about 2 $\mu$m. On to this layer an $\alpha$-Al$_2$O$_3$ layer consisting of about 10 $\mu$m. $\alpha$-Al$_2$O$_3$ was deposited according to this invention referred to as Coating a). The detailed process data is given below:

| Step 1:Bonding layer 1 | |
| --- | --- |
| Gas mixture | TiCl$_4$ = 2.8% |
| | CH$_3$CN = 0.7% |
| | AlCl$_3$ = increasing from 0.8 to 5.4% |
| | CO = 8.8% |
| | CO$_2$ = 2.2 % |
| | N$_2$..... = 5% |
| | Balance: H$_2$ |
| Duration | 40 min |
| Temperature | 1000 °C |
| Pressure | 100 mbar |

Step 2: N$_2$ purge

Step 3:Bonding layer 2

| Gas mixture | $TiCl_4$ = 8% |
|---|---|
| | CO =12% |
| | $CO_2$ =1.2% |
| | Ar.......... = 5% |
| | Balance: $H_2$ |
| Duration | 10 min |
| Temperature | 1000 °C |
| Pressure | 100 mbar |

*Step 3: (ALD steps): a)TiCl₄ treatment b) N₂-purge c) H₂O treatment d) N₂-purge*

| a) | $TiCl_4$=9% |
|---|---|
| | $AlCl_3$=1% |
| | $H_2$=balance |
| | 5 min................ |
| c) | $H_2O$=0.1% |
| | $H_2$= balance |
| | 2 min |
| | ................. |
| b, d) | $N_2$=100% |
| | 5 min |
| Temperature | 1000°C |
| Pressure | 50 mbar |

*Step 4: Nucleation step*

| Gas mixture | $AlCl_3$ | = 1,2 % |
|---|---|---|
| | HCl.....= 2.0 % | |
| | $CO_2$ | = 1.5 % |
| | CO | = 2.4% |
| | Balance | $H_2$ |
| Duration | 60 min | |
| Temperature | 1000°C | |
| Pressure | 50 mbar | |

*Step 5: Deposition*

| Gas mixture | $AlCl_3$ | = 2.8% |
|---|---|---|
| | HCl | = 3 % |
| | $CO_2$ | = 1.8% |
| | CO | = 3.6% |
| | $H_2S$ | = 0.01% |
| | $SF_6$ | = 0.01 % |
| | Balance: | $H_2$ |
| Duration | 630 min | |
| Temperature | 1000°C | |

(continued)

*Step 5: Deposition*

| Pressure | 70 mbar |
|---|---|

Example 2

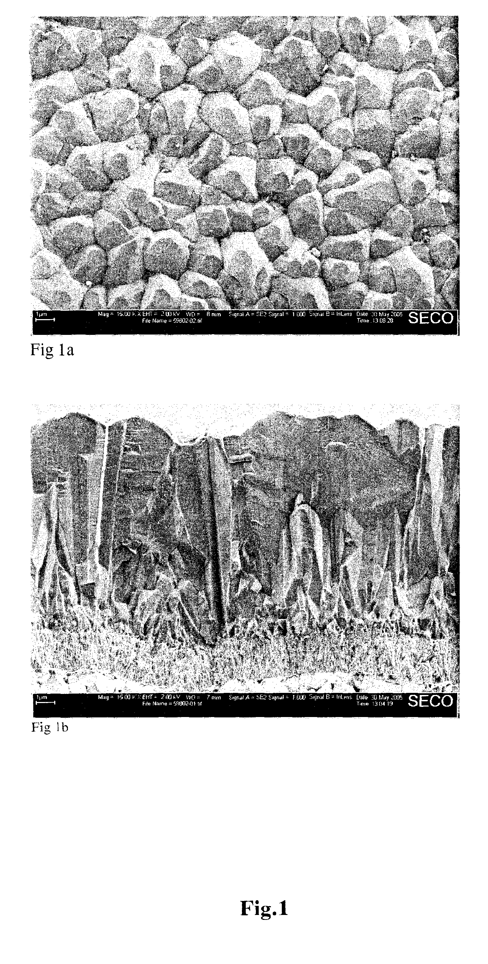

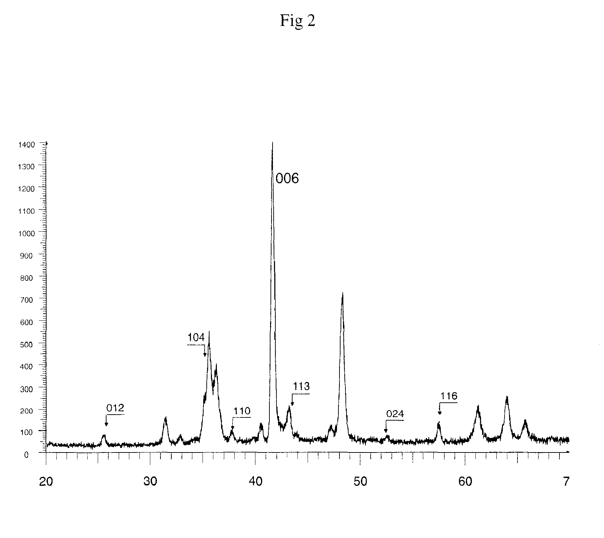

Coating a) was studied using X-ray diffraction. The texture coefficients of the $\alpha$-$Al_2O_3$ layers were determined and are presented in Table 1. A SEM micrograph of Coating a) in top view with <001> texture is shown in Fig 1a and in cross section in Fig 1b. The $\alpha$-$Al_2O_3$ layer was composed of columnar grains. The X-Ray diffraction pattern is shown in Fig. 2.

Table 1

| hkl | Coating a) |
|---|---|
| 012 | 0.01 |
| 104 | 0.06 |
| 110 | 0.01 |
| 006 | 5.91 |
| 113 | 0.00 |
| 116 | 0.02 |

Example 3

For reference Coatings b) and c) with <012> and <104> textures were deposited according to the prior-art (coating thickness about 10 $\mu$m). The coatings were studied using X-ray diffraction. The texture coefficients of the $\alpha$-$Al_2O_3$ layers were determined and are presented in Table 2.

Table 2.

| hkl | Coating a), invention | Coating b) | Coating c) |
|---|---|---|---|
| 012 | 0.03 | 5.15 | 0.16 |
| 104 | 0.06 | 0.13 | 4.27 |
| 110 | 0.01 | 0.10 | 0.08 |
| 600 | 5.88 | 0.00 | 0.09 |
| 113 | 0.00 | 0.18 | 0.66 |
| 116 | 0.02 | 0.44 | 0.74 |

Example 4

Coating a), b) and c) deposited on Co-enriched substrates were tested with respect to toughness in longitudinal turning with interrupted cuts.

| Work piece: | Cylindrical slotted bar |
|---|---|
| Material: | SS1672 |
| Insert type: | CNMG120408-M3 |
| Cutting speed: | 140 m/min |
| Feed: | 0.1, 0.125, 0.16, 0.20, 0.25, 0.315, 0.4, 0.5, 0.63, 0.8 mm/rev gradually |
| increased after | 10 mm length of cut |
| Depth of cut: | 2.5 mm |
| Remarks: | dry turning |

Tool life criteria: Gradually increased feed until edge breakage. 10 edges of each variant were tested.
The inserts were inspected after 2 and 4 minutes of cutting. As clear from Table 3 the edge toughness was considerably enhanced when the layer was produced according to this invention.

Table 3

| Experimental coating | Mean feed at breakage (mm/rev) |
| --- | --- |
| Coating a (006), according to the invention | 0.50 |
| Coating b (012) | 0.22 |
| Coating c (104) | 0.36 |

The test results show (Table 3) that the coating according to the invention (Coating a) exhibited clearly better toughness behaviour than the prior-art (Coatings b and c).

Example 5

The coatings a), b) and c) were tested with respect to edge chipping in longitudinal turning in cast iron.

| | |
| --- | --- |
| Work piece: | Cylindrical bar |
| Material: | SS0130 |
| Insert type: | SNUN |
| Cutting speed: | 400 m/min |
| Feed: | 0.4 mm/rev |
| Depth of cut: | 2.0 mm |
| Remarks: | dry turning |

The inserts were inspected after 2 and 4 minutes of cutting. As clear from Table 4 the edge toughness of the prior art product was considerably enhanced when the coating was produced according to this invention.

Table 4

| | Flaking of the edge line (%) after 2 minutes | Flaking of the edge line (%) after 6 minutes |
| --- | --- | --- |
| Coating a (Invention) | 0 | 5 |
| Coating b | 0 | 18 |
| Coating c | 5 | 10 |

Example 6

Cubic boron nitride (CBN) insert containing about 90 % of polycrystalline CBN (PCBN) were coated according to this invention and according to prior art Coating b). The coated CBN was compared with uncoated CBN insert in cutting of steel containing ferrite. It is known that B has a high affinity to ferrite and diffusion wear occurs at high cutting speeds.

| | |
| --- | --- |
| Work piece: | Cylindrical bar |
| Material: | SS0130 |
| Insert type: | SNUN |
| Cutting speed: | 800 m/min |
| Feed: | 0.4 mm/rev |
| Depth of cut: | 2.5 mm |
| Remarks: | dry turning |

Table 5

|  | Life time (min) |
| --- | --- |
| Coated CBN, Invention | 23 |
| Coated CBN, prior art, 012 texture | 14 |
| Uncoated CBN | 9 |

As is evident from Table 5 the coating according to this invention is superior to the prior art.

Example 7

The hardness and Young's modulus of the coatings a) - c) together with $\kappa$-$Al_2O_3$ and older prior-art $\alpha$-$Al_2O_3$ were measured using nanoindentation. The results are shown in Table 6.

Table 6

|  | Hardness (GPa) | Young's Modulus (GPa) |
| --- | --- | --- |
| Coating a | 28.92 | 444.42 |
| Coating b | 27.31 | 419.53 |
| Coating c | 28.81 | 441.17 |
| Prior-art $\alpha$-$Al_2O_3$ (no texture) | 25.79 | 385.45 |
| $\kappa$-$Al_2O_3$ | 23.64 | 339.51 |

Coating c) according to the invention shows the highest values of hardness and modulus, closely followed by coating c).

**Claims**

1. Cutting tool insert consisting of a substrate at least partially coated with a coating with a total thickness of 5-40 $\mu$m, preferably 5-25 $\mu$m consisting of one or more refractory layers of which at least one layer is an $\alpha$-alumina layer **characterized in** said alumina layer being composed of columnar $\alpha$-$Al_2O_3$ grains with preferred <001> growth direction with texture coefficients

a) TC(006) >1.4, preferably >3.0 and most preferably >4.0.
the texture coefficient TC(hkl) being defined as

$$TC(hkl) = \frac{I(hkl)}{I_0(hkl)} \left\{ \frac{1}{n} \sum \frac{I(hkl)}{I_0(hkl)} \right\}^{-1}$$

where
I(hkl) = measured intensity of the (hkl) reflection
$I_0$(hk1) = standard intensity according to JCPDS card no 46-1212
n = number of reflections used in the calculation
(hkl) reflections used are: (012), (104), (110),
(006), (113) and (116).

2. Cutting tool insert according to claim 1 **characterized in** said alumina columnar grains having a length/width ratio from 2 to 15, preferably 5 to 10.

3. Cutting tool insert according to any of the previous claims **characterized in that** said substrate comprises cemented carbide preferably with a binder phase enriched surface zone, CBN or sintered CBN alloy.

4. Cutting tool insert according to any of the previous claims **characterized in that** the coating comprises a first layer adjacent the body of CVD Ti(C,N), CVD TiN, CVD TiC, MTCVD Ti(C,N), MTCVD Zr(C,N), MTCVD Ti(B,C.N), CVD HfN or combinations thereof preferably of Ti(C,N) having a thickness of from 1 to 20 $\mu$m, preferably from 1 to 10 $\mu$m and said $\alpha$-Al$_2$O$_3$ layer adjacent said first layer having a thickness of from about 1 to 40 $\mu$m, preferably from 1 to 20 $\mu$m, most preferably from 1 to 10 $\mu$m.

5. Cutting tool insert according to any of the previous claims **characterized in that** the $\alpha$-Al$_2$O$_3$ layer is the uppermost layer.

6. Cutting tool insert according to any of the previous claims **characterized in that** a layer of carbide, nitride, carbonitride or carboxynitride of one or more of Ti, Zr and Hf, having a thickness of from about 0.5 to 3 $\mu$m, preferably 0.5 to 1.5 $\mu$m atop the $\alpha$-Al$_2$O$_3$ layer.

7. Cutting tool insert according to any of claims 1-6 **characterized in** a layer of carbide, nitride, carbonitride or carboxynitride of one or more of Ti, Zr and Hf, having a thickness of from about 1 to 20 $\mu$m, preferably 2 to 8 $\mu$m, atop the $\alpha$-Al$_2$O$_3$ layer.

8. Cutting tool insert according to any of the previous claims **characterized in** a layer of $\kappa$-Al$_2$O$_3$ or $\gamma$-Al$_2$O$_3$ atop the $\alpha$-Al$_2$O$_3$ with a thickness of from 0.5 to 10 $\mu$m, preferably from 1 to 5 $\mu$m.

9. Cutting tool insert according to any of the previous claims **characterized in** a layer of TiN between the substrate and said first layer with a thickness of <3 $\mu$m, preferably 0.5-2 $\mu$m.

10. Method of making an $\alpha$-Al$_2$O$_3$ layer according to claim 1 in a temperature range of 750-1000°C **characterized in that** the growth of the said $\alpha$-Al$_2$O$_3$ is obtained by optimising both the nucleation surface and the growth of $\alpha$-Al$_2$O$_3$ using sulphur-containing and fluorine-containing precursors such as H$_2$S or SF$_6$ or SO$_2$ or SF$_6$.

Fig 1a

Fig 1b

**Fig.1**

Fig 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5137774 A
- US 5654035 A
- US 5980988 A
- US 5863640 A
- US 6333103 B
- US 6869668 B
- US 20040028951 A1

### Non-patent literature cited in the description

- **S. RUPPI.** Deposition. Microstructure and properties of texture-controlled CVD $\alpha$-Al2O3 coatings. *Int. J. Refractory Metals & Hard Materials,* 2005, vol. 23, 306-315